# EUROPÄISCHE PATENTSCHRIFT

(11) **EP 0 749 347 B1**
(45) Veröffentlichungstag und Bekanntmachung des Hinweises auf die Patenterteilung: **10.06.1998**
(21) Anmeldenummer: 95909913.6
(22) Anmeldetag: 08.03.1995
(51) Int. Cl.: B01D 35/28, B01D 29/90, B01D 33/073, G03F 7/42

(54) **VERFAHREN UND VORRICHTUNGEN ZUM ENTSCHICHTEN VON LEITERPLATTEN**
PROCESSES AND DEVICES FOR REMOVING COATING LAYERS FROM PRINTED CIRCUIT BOARDS
PROCEDES ET DISPOSITIFS D'ENLEVEMENT DE COUCHES DE CIRCUITS IMPRIMES

(30) Priorität: 08.03.1994 US 207991
(43) Veröffentlichungstag der Anmeldung: 27.12.1996
(73) Patentinhaber: ATOTECH DEUTSCHLAND GMBH, 10553 Berlin (DE)
(72) Erfinder: BARON, David, T., Brewdley Worcestershire DY12 1QF (GB); TAYLOR, Alexander, R., Barassie Troon Ayrshire KA10 7JY (GB); JOHAL, Kuldip, S., Willenhall West Midlands WV13 3EJ (GB)
(74) Vertreter: Effert, Udo, Dipl.-Ing.
(86) Internationale Anmeldenummer: IB9500145
(87) Internationale Veröffentlichungsnummer: WO9524257

(56) Entgegenhaltungen:
- EP-A- 0 023 899
- EP-A- 0 267 437
- WO-A-86/06648
- DE-A- 3 638 371
- GB-A- 2 050 855
- GB-A- 2 061 748
- US-A- 3 833 123
- US-A- 4 202 777
- US-A- 4 626 349
- US-A- 4 661 235
- US-A- 4 760 014

## Beschreibung

Die Erfindung betrifft Verfahren und Vorrichtungen zum Entfernen von quellbaren Polymerteilchen aus einer flüssigen Dispersion.

In bekannten Verfahren zum Erzeugen von Leiterstrukturen auf Leiterplatten wird das mit Kupfer beschichtete Leiterplattenlaminat zunächst mit photoempfindlichen Polymerkombinationen (Photoresisten) beschichtet, anschließend die beschichtete Schicht zur Erzeugung einer Struktur einer elektromagnetischen Strahlung ausgesetzt und die Struktur auf dem Resist entwickelt. Die nicht entwickelten Teile der Resistschicht werden entfernt, die nicht mehr mit Resist bedeckte Kupferschicht abgeätzt, und die verbleibenden Resistteile werden schließlich durch In-Kontakt-Bringen der Leiterplatte mit einem Entschichtungsmittel behandelt, wobei eine Dispersion des entfernten Resists in Form von Resistteilchen im Entschichtungsmittel gebildet wird.

Die Entschichtungslösung wird verwendet, um den Resist von einer Leiterplatte zu entfernen, damit eine Schaltungsart gewünschter Anordnung erreicht wird. In bekannten Verfahren wird die Entschichtungslösung danach entweder verworfen, oder der Resist wird von ihr entfernt, damit die Lösung wiederverwendet werden kann.

Aus wirtschaflichen Gründen ist die letztgenannte Verfahrensweise vorzuziehen. Nach den im Stande der Technik bekannten Entfernungsmethoden führt das Abfiltrieren der Resistteilchen zu einer Veränderung der Entschichtungslösung. Andererseits ist ein Behandeln der Dispersion mit dem Filtermittel mit einer geeigneten Vorrichtung erforderlich, wobei erhebliche Probleme auftreten, wie beispielsweise das Verstopfen der Filter, die Pflege und Wartung der Vorrichtung und die Beseitigung der Hilfs- und Reststoffe. Außerdem ist das Filterverfahren der die Partikel enthaltenden Entschichtungslösung für eine ausreichende Trennung sowohl zeitaufwendig als auch arbeitsintensiv und somit unwirtschaftlich.

Nach der üblicherweise verwendeten Methode erfolgt die Abtrennung der Resistteilchen aus den Entschichtungslösungen beispielsweise mittels eines Hydrozyklonfilters, in dem die Lösung durch einen konischen Hohlkörper gepumpt und dabei in schnelle Drehbewegungen versetzt wird. Die Flüssigkeit wird herumgewirbelt, und die dabei entstehende Zentrifugalkraft bewirkt eine Abtrennung von etwa 40% der Resistpartikel aus der Lösung durch eine Siebfiltrierung. Die gefilterte Lösung mit den bei der Filtrierung nicht beseitigten Resistteilchen wird für die erneute Verwendung im Entschichtungsverfahren wiederaufbereitet. Die zurückgehaltenen Teilchen werden vom Filtersieb auf geeignete Weise, wie beispielsweise durch Abkratzen oder durch Wasserspülung, entfernt und anschließend beseitigt.

Da die meisten Teilchen in der Filterlösung zurückbleiben, nimmt die Wirksamkeit der Lösung als Resistentschichtungsmittel allmählich ab, so daß die Filterlösung relativ oft durch frische Lösung ersetzt werden muß (wöchentlich oder häufiger).

Außerdem muß die Leiterplattenfertigung in diesem Falle im allgemeinen stillgelegt werden, was zu einem Verlust an Produktionszeit und Kosten für nichtproduktiven Produktionsausfall führt.

Es sind jedoch noch andere Wege zur Abtrennung des entschichteten Resists aus den Entschichtungslösungen bekannt. So wird in US-A-47 60 014 eine Vorrichtung zur Herstellung und Entschichtung von Leiterplatten beschrieben, wobei zur Entfernung der Resistteilchen aus der gebildeten Dispersion nach einer ersten Filtration eine Säure zur Resist-Entschichtungslösung zugegeben wird, damit der Resist in halbwegs nicht klebrigen kleinen Teilchen gerinnen kann, die dann von der flüssigen Phase mit geringem Aufwand durch erneute Filtration beseitigt werden können (Fig. 6 und 7). Es ist zu beachten, daß die Entschichtungslösung nach dieser Behandlung verändert ist.

In anderen Druckschriften werden verschiedene Filtrierungsverfahren und hierfür geeignete Vorrichtungen offenbart, wobei die die Feststoffteilchen enthaltende Flüssigkeit durch Filtermaterialien, beispielsweise Stahlwolle, gewebte Metallnetze oder auch elastische Fasermaterialien, wie Glasfasern, oder Kunststoffbänder, getrennt wird. Derartige Verfahren und Vorrichtungen werden insbesondere für die Abtrennung von Silber aus verbrauchten für den photographischen Prozeß verwendete Lösungen eingesetzt (US-A-50 26 029, US-A-44 41 697, US-A-42 40 617, US-A-37 44 995, US-A-30 43 432, US-A-29 05 323, US-A-37 92 845, US-A-43 25 732, US-A-46 62 613) oder zum Neutralisieren von verbrauchten Lösungen und Ausfällen von Feststoffen aus den Lösungen (US-A-46 08 177).

In US-A-46 61 253 ist eine Vorrichtung zur Fest-Flüssig-Ausscheidung von tierischem Abfall aus einem wäßrigen Trägerstrom über ein Sieb beschrieben, das in einem Winkel von etwa 60° zur Waagerechten gehalten wird, wobei oszillierende Hochdruck-Wasserstrahlen auf die untere Fläche des Siebes auftreffen, so daß eine Verstopfung der Sieblöcher mit aus Partikeln bestehenden Stoffen behindert wird.

In der DE-A-36 38 371 A1 ist eine Vorrichtung zur Trennung von in einer Flüssigkeit, insbesondere von in Abwässern, enthaltenen Feststoffen beschrieben, die ein Bogen- oder Schrägsieb aufweist, das in einem Winkel zur Vertikalen geneigt ist, so daß mittels des Siebes abgetrennte Feststoffe auf diesem nach unten abrutschen können.

In GB-A-20 61 748 ist eine Flüssig-Fest-Trenneinrichtung beschrieben, in der mehrere Trennsiebe in verschiedenen geneigten Stellungen gegen die Vertikale vorgesehen sind und bei der die die Feststoffe enthaltende Flüssigkeit von oben auf die Siebe aufgegeben wird.

In GB-A-20 50 855 ist eine Vorrichtung zum Abtrennen geronnener Milch von Molke beschrieben, die ebenfalls im wesentlichen ein geneigtes Sieb aufweist, auf das die Flüssigkeit von oben aufgegeben wird, um die Trennung vorzunehmen.

In US-A-46 26 329 (Uphus) ist die physikalische Ausscheidung von Flüssigkeiten und Feststoffen beschrieben, bei der ein Trägerstrom mit darin enthaltenen dispergierten Festkörpern über ein Sieb fließt, dessen Neigung zur Horizontalen verändert werden kann. Ein umgekehrter Trichter am Einlaß für den Flüssigkeitsstrom in die Vorrichtung und in der Vorrichtung angeordnete Trennwände sollen die Geschwindigkeit des Trägerstroms verringern. Die Vorrichtung sieht keine Mittel zum Rückführen der abgetrennten Flüssigkeit zum Behandlungsprozeß vor, in dem die Flüssigkeit die dispergierten Festkörper aufgenommen hat.

In der US-A-42 02 777 wird ein Sieb mit geneigter und gekrümmter Filterfläche beschrieben. Die Verteileinrichtung weist ein radial gespeistes Innenrohr und ein Außenrohr mit Schlitz auf.

In US-A-38 33 123 ist eine Vorrichtung mit geneigtem Sieb, vorzugsweise zur Behandlung von bei der Papierherstellung anfallenden Stoffströmen, beschrieben, mit der ein Trägerstrom in seine festen und flüssigen Bestandteile aufgetrennt werden kann. Die Vorrichtung enthält Trennwände, um die Oberflächenspannung des Filtrats, das an der unteren Seite des Siebs anhaftet, zu verringern. Diese Form der Vorrichtung ähnelt der in US-A-46 61 253 beschriebenen Vorrichtung. Es werden auch hier gesprühte Wasserstrahlen beschrieben, damit das Sieb nicht verstopft.

In der US-A-48 67 879 ist eine Vorrichtung zum mechanischen Reinigen von Flüssigkeiten beschrieben, bei der ein rotationssymmetrisches Sieb in einer entsprechenden Siebkammer in einem Winkel von 30 ° bis 60 ° zur Achse der Siebkammer angeordnet ist und bei eine Einrichtung vorgesehen ist, mit der auf dem Sieb anhaftende Rückstände durch ständiges Abwischen entfernt werden können.

In der EP-A-0 023 899 sind Vorrichtungen offenbart, welche die konstruktiven Merkmale der Oberbegriffe der Ansprüche 7 und 8 aufweisen.

Bei Anwendung der bekannten Verfahren ist die Kontaktzeit der zu entfernenden Teilchen mit der Lösung relativ lang, so daß die Gefahr einer Auflösung quellbarer Teilchen, beispielsweise von Resistteilchen, in der Lösung besteht. In keiner der angegebenen Druckschriften wird diese gefahr angesprochen, oder eine Verringerung der Verfahrensdauer in Betracht gezogen das Problem angegeben.

Der vorliegenden Erfindung lag von daher das Problem zugrunde die Nachteile nach dem Stande der Technik zu vermeiden und Verfahren und geeignete Vorrichtungen zum Entfernen von quellbaren Polymerteilchen aus einer flüssigen Dispersion bereitzustellen, bei dem das zum Entfernen von Polymerteilchen aus der Dispersion verwendete Trennmittel nicht verstopft und die Auflösung quellbarer Teilchen möglichst weitgehend reduziert wird.

Das Problem wird gelöst durch die Ansprüche 1, 2, 7, 8 und 15. Bevorzugte Ausführungsformen der Erfindung sind in den Unteransprüchen angegeben. Die erfindungsgemäße Lösung hat zur Folge, daß die Verfahrensdauer und die Verweilzeit der Teilchen in der Dispersion minimiert wird.

Die Erfindung umfaßt insbesondere Verfahren zum Entfernen von quellbaren Polymerteilchen aus einer flüssigen Dispersion, bestehend aus einer Lösung und darin enthaltenen, von der Lösung quellbaren Polymerteilchen, umfassend die in den Kennzeichen der Ansprüche 1 bzw. 2 angegebenen Verfahrensschritte, so daß die Polymerteilchen kontinuierlich aus der Dispersion entfernt werden.

Die Vorrichtungen zur Durchführung des Verfahren umfassen die in den Ansprüchen 7 bzw. 8 angegebenen Merkmale.

Das Verfahren kann insbesondere auch zum Entfernen von Resisten von Leiterplattenoberflächen mit den Verfahrensschritten
- In-Kontakt-Bringen der Leiterplattenoberflächen mit einer Lösung, enthaltend eine oder mehrere der Verbindungen a), b) und c):
   a) Alkanolamine, insbesondere Methanolamin, Ethanolamin, Dimethanolamin, Diethanolamin, Trimethanolamin, Triethanolamin und HO-C₂H₄-NH-C₂H₄-NH₂, Ethylendiamintetraessigsäure und deren Salze, Cholin und dessen Salze
   b) eine ionische Stickstoffverbindung mit der allgemeinen Formel

      (N_{y}R'''_{w})⁺(A)⁻,

      - wobei: R''' = substituierte oder unsubstituierte, lineare oder verzweigte Alkylgruppe mit 1 bis 10
      Kohlenstoffatomen mit Substituenten, ausgewählt aus der Gruppe der Wasserstoff-, Halogen-, Sauerstoff-, Stickstoff- oder Schwefelatome enthaltenden funktionellen Gruppen,
      A = ein anorganisches oder organisches Anion,
      y gleich 1 und
      w gleich 4 ist, sowie
   c) ein Alkali-oder Erdalkalimetallhydroxid,
      wobei eine Resistteilchen enthaltende Dispersion gebildet wird,
- Abtrennen der Resistteilchen aus der Dispersion mit dem erfindungsgemäßen Verfahren, wobei eine von Resistteilchen im wesentlichen freie Lösung gebildet wird,
- In-Kontakt-Bringen der Leiterplattenoberfläche mit der von Resistteilchen im wesentlichen freien Lösung,
   eingesetzt werden.

Zur Homogenisierung passiert die Dispersion Homogenisiereinrichtungen und wird anschließend mit geeigneten Trennmitteln in Kontakt gebracht, um die Teilchen von der Flüssigkeit zu trennen und die Lösung nach der Auftrennung in Lösung und Polymerteilchen zurückzugewinnen.

Als Trennmittel werden solche mit gegenüber der Vertikalen geneigter Filterfläche verwendet. Als besonders gut geeignet haben sich flache Siebe herausgestellt, wobei die Siebebene vorzugsweise in einem Winkel von etwa 35 ° bis etwa 85 ° gegen die Horizontale geneigt und in der Neigung verstellbar ist. Als Trennmittel können auch zylindrische, drehbare und parallel zum Schlitz in der Homogenisier- und Verteileinrichtung angeordnete Siebe verwendet werden.

Für eine wirksame Trennung haben sich insbesondere Siebe mit Maschenöffnungen von etwa 60 µm bis etwa 250 µm Größe, vorzugsweise von 90 µm bis 150 µm und besonders bevorzugt unterhalb von 120 µm, als günstig herausgestellt. Besonders gut geeignet sind Siebe mit Maschenöffnungen von etwa 75 µm bis etwa 120 µm Größe, mit einer Maschendichte von etwa 50 Maschen/cm bis etwa 85 Maschen/cm und einer Fadendicke von etwa 35 µm bis etwa 65 µm.

Um eine homogene Dispersion und einen gleichmäßigen Auftrag der Dispersion auf die Sieboberfläche zu erreichen, wird die Dispersion vor dem Auftrag auf das Sieb zunächst mittels einer oberhalb der Trenneinrichtung angeordneten Homogenisier- und Verteileinrichtung, vorzugsweise bestehend aus mehreren koaxial ineinander angeordneten perforierten Rohren, homogenisiert.

Die Homogenisierung wird dadurch bewirkt, daß die Dispersion innerhalb der Einrichtung mehrfach umgelenkt wird. Das innere Rohr der Einrichtung weist hierzu mehrere Öffnungen auf und ist gegenüber dem äußeren Rohr fixiert. Das äußere Rohr weist einen auf der Mantellinie des Rohres angeordneten und sich im wesentlich über die gesamte Länge des Rohres erstreckenden Schlitz als Perforation auf.

Die Position des Schlitzes ist vorzugsweise gegenüber der Position der Trenneinrichtung in der Vertikalen einstellbar. Vorzugsweise kann der Schlitz in einem Winkel von etwa 45 ° bis etwa 90 ° gegenüber der Vertikalen angeordnet sein. Der Schlitz ist dem Sieb im wesentlichen gegenüberliegend angeordnet.

Durch Wahl einer ausreichend hohen Strömungsgeschwindigkeit der Dispersion in der gesamten Behandlungsanlage können Verweilzeiten der Polymerteilchen in der Dispersion von im Mittel 20 Sekunden bis 5 Minuten erreicht werden.

Nach der Abtrennung der Polymerteilchen von der Behandlungslösung kann diese zur weiteren Verwendung wieder aufgearbeitet und in einen Behandlungsbehälter zurückgeführt werden.

In der bevorzugten erfindungsgemäßen Ausführungsform werden das Verfahren und die Vorrichtung zur Abtrennung von aus quellbaren polymeren Resistteilchen bestehenden Festkörpern aus einer Lösung zum Entschichten von Leiterplatten verwendet.

Nach dem erfindungsgemäßen Verfahren werden quellbare in einer Entschichtungslösung enthaltene polymere Resistteilchen über ein Sieb gegeben, wobei dabei die Resistteilchen von der Lösung abgetrennt werden. Danach wird die Entschichtungslösung erneut zur Kontaktierung mit der Leiterplatte in den Prozeßkreislauf gebracht. Während dieses Zyklus' verweilen die Resistteilchen in dem Entschichtungsmittel nur eine minimale Zeitdauer. Als Verweilzeit wird die Zeitdauer definiert, in der die quellbaren Polymerteilchen, insbesondere die beim Entschichten von Leiterplatten erzeugten Resistteilchen, mit der Lösung in Berührung kommen.

Als Entschichtungsmittel wird eine wäßrige Lösung verwendet, enthaltend eine oder mehrere Verbindungen a), b) und c):
a) Alkanolamine, insbesondere Methanolamin, Ethanolamin, Dimethanolamin, Diethanolamin, Trimethanolamin, Triethanolamin und HO-C₂H₄-NH-C₂H₄-NH₂, Ethylendiamintetraessigsäure und deren Salze, Cholin und dessen Salze,
b) eine ionische Stickstoffverbindung mit der allgemeinen Strukturformel

   (N_{y}R'''_{w})⁺(A)⁻,

   - wobei: R''' = substituierte oder unsubstituierte lineare oder verzweigte Alkylgruppe mit 1 bis 10 Kohlenstoffatomen mit Substituenten, ausgewählt aus der Gruppe der Wasserstoff-, Halogen-, Sauerstoff-, Stickstoff- oder Schwefelatome enthaltenden funktionellen Gruppen,
   A = ein anorganisches oder organisches Anion,
   y gleich 1 und
   w gleich 4 ist sowie
c) ein Alkali- oder Erdalkalimetallhydroxid.

Insbesondere werden als Entschichtungslösungen wäßrige Lösungen verwendet, enthaltend 1 bis 80 Gew.-% mindestens einer der vorgenannten Verbindungen, vorzugsweise in einer Konzentration von 5 Gew.-% bis etwa 50 Gew%. Der pH-Wert der Lösung kann im Bereich von etwa 9,5 bis etwa 13,5 liegen. Als besonders geeignete Amine haben sich Alkanolamine herausgestellt.

Bevorzugte Entschichtungsmittel sind wäßrige Lösungen aus Ethylendiamintetraessigsäure (EDTA) und deren Salze, Tetramethylammoniumhydroxid, Cholin sowie deren Derivate, wobei die Derivate beispielsweise Ester, Ether, Thiole oder Halogen enthaltende funktionelle Gruppen enthalten.

Die Entschichtungslösung kann ferner mindestens eine oberflächenaktive Verbindung enthalten. Bevorzugte oberflächenaktive Verbindungen sind ethoxylierte tertiäre Amine mit der allgemeinen Formel

R''''N[(CH₂CH₂O)_{b}H]₂

- geeignet, wobei: R'''' der Rest einer Fettsäure mit etwa 6 bis 20 Kohlenstoffatomen ist, und
b = 2 bis etwa 50, das für beide Ethylenoxid-Gruppen gleich oder unterschiedlich sein kann.

Die bevorzugten oberflächenaktiven Verbindungen sind nichtionisch.

Die Temperatur der Entschichtungslösung wird auf etwa 40 °C bis etwa 60 ° C eingestellt, vorzugsweise auf etwa 45 °C bis etwa 55°C.

Die Vorrichtung umfaßt neben den Mitteln zum Zuführen der Dispersion zu der Homogenisier- und Verteileinrichtung, der Homogenisier- und Verteileinrichtung selbst, und der Trenneinrichtung weitere Einrichtungen zum Umwälzen der Dispersion bzw. der Lösung durch die Entschichtungsanlage und die erfindungsgemäße Vorrichtung.

Als Einrichtungen zum Umwälzen der Lösung sind im allgemeinen Pumpen oder ähnliche Einrichtungen geeignet. Als Umwälzvorrichtung wird üblicherweise eine Pumpe zum Zurückführen der Entschichtungslösung zur Entschichtungsanlage eingesetzt.

Beim Entfernen des Resists von den Leiterplattenoberflächen entsteht die zu trennende Dispersion aus Resistteilchen und Entschichtungslösung. Diese wird zunächst in die Homogenisier- und Verteil- und von dort auf die erfindungsgemäße Trenneinrichtung, vorzugsweise ein Sieb, geleitet. Die Entschichtungslösung wird in geeigneten Behältern aufgefangen, die vorzugsweise unterhalb der Trenneinrichtung angeordnet sind. Außerdem sorgen Umwälzeinrichtungen dafür, daß die zurückgewonnene Entschichtungslösung zur Resistentschichtungsanlage wieder zurückgeführt wird.

Das Sieb kann flach oder zylindrisch sein. Die Winkelposition des vorzugsweise einstellbaren Schlitzes in der Homogenisiereinrichtung wird als der Winkel definiert, der durch eine die Mittellinie sowohl des Schlitzes als auch des äußeren konzentrischen Rohres passierende Linie gebildet wird.

In der am meisten bevorzugten erfindungsgemäßen Ausführungsform gehören zu der Filterausrüstung ein nichtrostendes Sieb mit Öffnungen von etwa 60 µm bis 150 µm Größe, vorzugsweise von 90 µm bis 110 µm. Als Entschichtungslösung wird eine wäßrige Lösung mit Ethanolamin in einer Konzentration von 5 Gew.-% bis 40 Gew.-% und einer oberflächenaktiven Verbindung mit einem Gehalt von etwa 0,05 Gew.-%, verwendet.

Bei einer weiteren, im folgenden detailliert beschriebenen erfindungsgemäßen Vorrichtung wird ein zylindrisches, drehbares und parallel zum Schlitz in der Homogenisier- und Verteileinrichtung angeordnetes Sieb in Verbindung mit einer Entschichtungslösung benutzt, um eine Abtrennung der Resistteilchen von der Lösung zu bewirken.

Die durch die Entschichtung des Resists von den Leiterplatten mit Resistteilchen angereicherte Entschichtungslösung wird zu der mit der Entschichtungsanlage verbundenen Homogenisier- und Verteileinrichtung mittels üblicher Einrichtungen, wie beispielsweise Pumpen, befördert und anschließend auf die Filter-Trenneinrichtung, wie ein Sieb, gegeben. Die Filtriereinrichtung ist vorzugsweise an Einrichtungen befestigt, die die Homogenisier- und Verteileinrichtung abstützen oder mit diesen in einer kompakten Einheit verbunden, und so angebracht, daß die flüssige Dispersion von der Homogenisier- und Verteileinrichtung auf die Filtriereinrichtung auftrifft. Da die Lösung am Sieb entlang läuft, fließt der flüssige Bestandteil der Dispersion durch und über die Maschen des Siebes in unterhalb davon angeordnete Sammelbehälter, wie beispielsweise einen Kübel oder einen Tank, indem sie einer Beschleunigungskraft ausgesetzt werden, beispielsweise der Schwerkraft. Die nicht in der Entschichtungslösung aufgelösten Resistteilchen werden auf der Oberfläche des Siebes zurück gehalten. Die Flüssigkeit in den Vorratsbehältern wird dann vorzugsweise durch eine angeschlossene Einrichtung zur Umwälzung der zurückgewonnenen Lösung, wie beispielsweise einer Pumpe, zum Entschichten wieder aufbereitet.

Bei dem erfindungsgemäßen Verfahren sind das Entschichtungsmittel und die Resistteilchen für eine kürzere Zeit miteinander in Kontakt als bei herkömmlichen Verfahren. Es wird eine kurze Verweilzeit von etwa 20 Sekunden bis etwa 5 Minunten und vorzugsweise von etwa 30 Sekunden bis etwa 2 Minuten erreicht. Mit Verfahren nach dem Stand der Technik waren die Resistteilchen mit der Entschichtungslösung etwa 10 Minuten bis etwa 30 Minuten in Kontakt.

Mit dem erfindungsgemäßen Verfahren lösen sich die Resistteilchen in dem Entschichtungsmittel daher in bedeutend geringerem Umfange auf, so daß die Entschichtungslösung fast unbeschränkt wieder verwendet werden kann. Eine Wiederverwendung der Entschichtungslösung nach dem erfindungsgemäßen Verfahren ist dann möglich, wenn der Lösung in kleinen Mengen frische Lösung zugegeben wird. Im Gegensatz hierzu ist eine Wiederverwendung von nach herkömmlichen Verfahren von den Resistteilchen befreiten Lösungen nur begrenzt möglich. Beispielsweise kann eine Entschichtungslösung über 100 mal wieder aufgearbeitet werden. Dadurch wird die Wirtschaftlichkeit der Entschichtungslösung erheblich erhöht, da viel weniger Entschichtungsmittel verbraucht wird. Außerdem wird die Umwelt infolge des geringeren Anfalls von Abwasser und sonstigem Abfall in geringerem Umfange belastet.

In den Figuren 1 bis 5 sind die erfindungsgemäßen Vorrichtungen schematisch und beispielhaft dargestellt.

Es zeigen:
- Fig. 1:: eine Seitenansicht der gesamten Vorrichtung;
- Fig. 2.: eine Vorderansicht der Homogenisier- und Verteileinrichtung und des Siebes;
- Fig. 3:: eine Ansicht entlang dem Schnitt 3 - 3 der Fig. 2;
- Fig. 4:: eine weitere Ausführungsform der Vorrichtung;
- Fig. 5:: eine Vorrichtung, die mit der Entschichtungsvorrichtung für Leiterplatten verbunden ist.

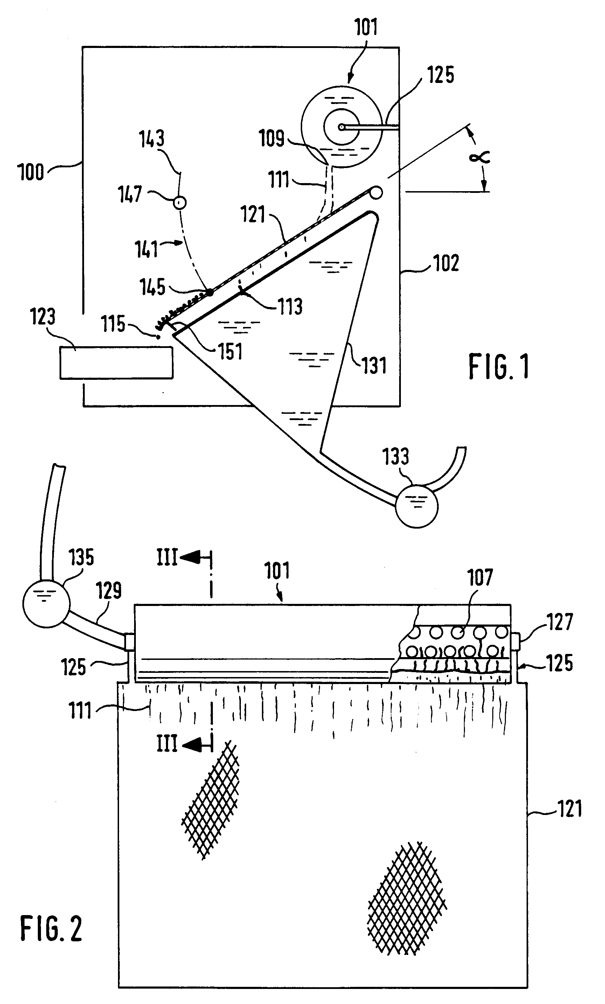

In Fig. 1 ist die Einrichtung 100 dargestellt. Sie umfaßt eine Homogenisier- und Verteileinrichtung in Form zweier koaxial ineinander angeordneter perforierter Rohre 101, durch eine Stützvorrichtung 125 drehbar gelagert und befestigt am Rahmen 102. Die Lösung 111 fließt durch den Schlitz 109 von der Homogenisier- und Verteileinrichtung 101 herunter und trifft auf das entsprechend unterhalb der Homogenisier- und Verteileinrichtung angeordnete flache Sieb 121. Die Siebebene des Siebes ist in einem Winkel α zur Waagerechten eingestellt. Zur Justierung der Siebneigung dient eine Justiervorrichtung 141, die in der Figur als eine drehbar am Sieb am Punkt 145 befestigte Stange 143 dargestellt ist. Zur Arretierung wird üblicherweise eine Klemmschraube 147 oder ein ähnliches Mittel verwendet. Es ist ausreichend, daß der Winkel α des Siebes zur Waagerechten etwa 25 ° bis etwa 85°, vorzugsweise etwa 35° bis etwa 85° verändert werden kann. In der Fig. sind weitere Einzelheiten, wie elektrische, mechanische Einrichtungen und Mittel sowie Rohrleitungsverbindungen, die zum Betrieb der Vorrichtung erforderlich sind, nicht dargestellt.

Die Dispersion 111 besteht aus der Entschichtungslösung 113 und den Resistteilchen 115. Während sich die Dispersion 111 unter dem Einfluß der Schwerkraft am Sieb entlang nach unten bewegt, passiert die Entschichtungslösung 113 das Sieb 121 und fällt in den Vorratsbehälter 131. Vom Vorratsbehälter 131 wird die Entschichtungslösung 113 vorzugsweise durch Pumpen 133 zur Wiederaufbereitung der Lösung zu einer geeigneten Vorrichtung transportiert, kann aber auch wahlweise verworfen oder anderweitig behandelt werden. Die Resistteilchen 115 fließen weiter am Sieb entlang nach unten und fallen in den Sammler 123. Vom Sammler 123 werden die Resistteilchen 115 nach entsprechender Behandlung im allgemeinen verworfen.

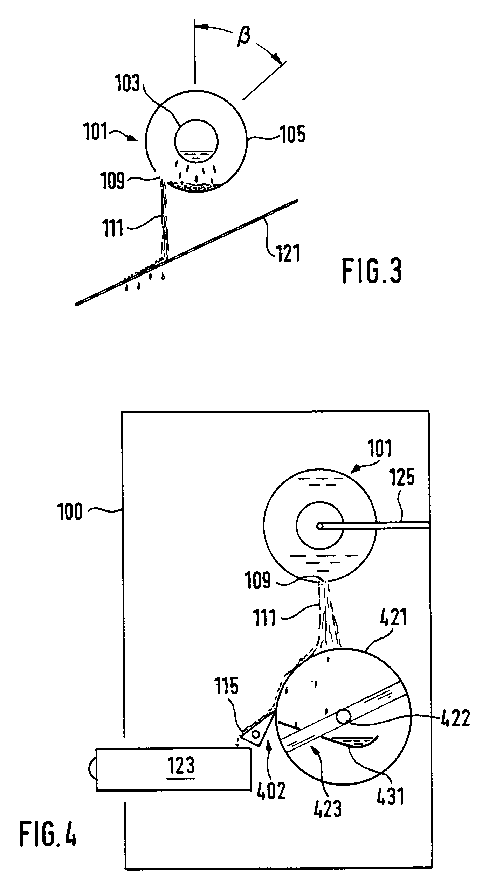

In den Fig. 2 und 3 ist die Homogenisier- und Verteileinrichtung 101 dargestellt. Diese besteht aus dem Außenrohr 105 und dem konzentrisch im Außenrohr angeordneten Innenrohr 103. Das Innenrohr weist eine Vielzahl von Löchern 107 auf, um eine Verbindung des Inneren des Innenrohres 103 mit dem Zwischenraum zwischen Innenrohr 103 und Außenrohr 105 herzustellen. Im Außenrohr ist ein Schlitz 109 vorgesehen. Dieser verläuft am Außenrohr 105 entlang, vorzugsweise an der Mantellinie. Der Schlitz 109 wird in einem Winkel von etwa 45° bis etwa 90° zur Vertikalen eingestellt. Hierzu wird die Homogenisier- und Verteileinrichtung 101 drehbar auf der Stützvorrichtung 125 auf Stützpunkten 127 geführt. Die Zuführung 129 für die Dispersion 111 ist vorzugsweise an einem der Drehpunkte 127 mit der Homogenisier- und Verteileinrichtung 101 verbunden. Dadurch wird die Dispersion 111 in das Innenrohr 103 geleitet.

Die Dispersion 111 wird durch die Zuführung 129 mittels geeigneter Umwälzeinrichtungen 135, beispielsweise eine Pumpe, in das Innenrohr 103 befördert. Dabei sowie beim Transport der Dispersion durch die Homogenisier- und Verteileinrichtung 101 wird die Dispersion sowohl gründlich gemischt als auch suspendiert, so daß sich die Teilchen 115 in der Dispersion 111 gleichmäßig verteilen. Die Dispersion 111 fließt vom Innenrohr 103 in das Außenrohr 105 und anschließend vom Außenrohr 105 durch den Schlitz 109 auf das Sieb 121 herunter.

Das Sieb besteht vorzugswiese aus nichtrostendem Stahl, obwohl grundsätzlich jedes Material, das gegen die Lösung und die suspendierten Teilchen beständig ist, verwendet werden kann, einschließlich Glas, Nylon, Hochdruck-Polyethylen und Gold. Unabhängig vom Siebmaterial muß das Sieb jedoch von der Lösung benetzbar sein.

Je nach Bedarf können zur Dispersion geignete Mengen frischen Entschichtungsmittels zugegeben werden, um jede beliebige gewünschte physikalische oder chemische Eigenschaft der Dispersion, wie beispielsweise den pH-Wert, die Temperatur oder Viskosität aufrechtzuerhalten oder einstellen zu können.

Das Sieb 121 wird in einem Winkel α zur Waagerechten gehalten. Der Winkel α wird vorzugsweise in einem Bereich von etwa 35 ° bis etwa 85 °, insbesondere von etwa 40° bis etwa 75° und besonders bevorzugt von etwa 50° bis etwa 55°, eingestellt. Durch die Beibehaltung eines geeigneten Winkels kann die Dispersion 111 unter dem Einfluß der Schwerkraft am Sieb 121 entlang fließen, um eine Abtrennung der Resistteilchen 115 von der Entschichtungslösung 113 zu ermöglichen und außerdem zu bewirken, daß die Teilchen 115 weiter am Sieb 121 entlang abwärtsfließen und in einen Sammelbehälter 123 fallen, während die Entschichtungslösung 113 durch das Sieb 121 in das Sammelgefäß 131 fließt.

In Fig. 2 ist die Homogenisier- und Verteileinrichtung 101 teilweise im Schnitt gezeigt, wobei die Dispersion 111 vom Schlitz auf das Sieb 121 fließt. Das Innenrohr 103 mit den darin enthaltenen Löchern 107 bildet die Homogenisier- und Verteileinrichtung 101. Die herabfließende Dispersion 111 wird im Innenrohr 103 zumindest teilweise und beim Fließen von Innen- zum Außenrohr gründlich gemischt, um eine einheitliche Verteilung der Teilchen in der Dispersion zu erreichen. Die Dispersion 111 wird hierdurch außerdem auf der gesamten Breite der Homogenisier- und Verteileinrichtung 101 gleichmäßig verteilt, so daß sie gleichmäßig durch den Schlitz 109 des Außenrohres 105 auf das Sieb 121 fließen und diese auf der gesamten Breite benetzen kann.

Die Homogenisier- und Verteileinrichtung 103 ist daher das funktionelle Äquivalent einer Mischvorrichtung, mittels der die gemischte Dispersion 111 unter Druck auf dem Sieb 121 verteilt wird.

Wie zuvor erwähnt, kann der Winkel α des Siebes 121 von etwa 25 ° bis etwa 85° zur Waagerechten eingestellt werden, um die Fließgeschwindigkeit der Dispersion auf dem Sieb 121 und damit die Wirksamkeit der Trennung zu kontrollieren. Weiterhin kann der Winkel β, gebildet durch die Mittellinie des Schlitzes 109 mit der Mittellinie der Homogenisier- und Verteileinrichtung 101, eingestellt werden, indem die Homogenisier- und Verteileinrichtung 101 um die Drehpunkte 127 herum gedreht wird. Dadurch wird die Kraft eingestellt, mit der die Lösung 111 auf das Sieb 121 auftrifft. Ferner kann die Fließgeschwindigkeit natürlich auch durch die Pumpe 135 eingestellt werden. Der Winkel β kann jeden beliebigen Wert zwischen 0 und 90° einnehmen. Ein bevorzugter Bereich für β liegt zwischen etwa 45 ° und etwa 90°. Durch Einstellen der Winkel α und β kann die Abtrennung der Teilchen 115 von der Entschichtungslösung 113 bei wechselnder Temperatur, Produktionsgeschwindigkeit, Zusammensetzung der Entschichtungslösung und anderen bei der Herstellung von Leiterplatten relevanten und die Zusammensetzung der Dispersion 111 beeinflussenden Variablen optimiert werden.

Dem erfindungsgemäßen Verfahren liegt wahrscheinlich der folgende Funktionsmechanismus zugrunde, ohne daR die angegebene Deutung eine Beschränkung des Schutzumfanges der Erfindung darstellt: Die Dispersion 111, die beim Entschichten von Leiterplatten entsteht, bestehend aus der Entschichtungslösung 113 und den dispergierten Resistteilchen 115 eines von der Leiterplatte entfernten Photopolymers wird durch geeignete Zuführungen 129 mittels Pumpen 135 in eine Homogenisier- und Verteileinrichtung 101 befördert.Von dort fällt die gründlich gemischte Dispersion 111 vom Außenrohr 105 durch den Schlitz 109 auf das Sieb 121. Die Entschichtungslösung 113 passiert das Sieb 121 und hinterläßt die Resistteilchen 115 auf der oberen Fläche des Siebes 121. Durch die Oberflächenspannung der Entschichtungslösung 113 bleibt ein dünner Flüssigkeitsfilm auf den einzelnen Teilchen 115 zurück. Durch Schwerkraft wird eine Wanderung der Resistteilchen auf der Oberfläche des Siebes hervorgerufen und durch eine als Folge des unterhalb des Siebes am Sieb entlanglaufenden Hauptteiles der das Sieb passierenden Entschichtungslösung 113 entstehende sequentielle Venturi-Wirkung unterstützt, wobei jede Maschenöffnung als individuelle Vakuumpumpe wirkt, bevor die filtrierte Entschichtungslösung 113 vom Deflektor 151 in den Sammelbehälter 131 gelenkt wird. Überraschenderweise verstopfen die durch das Verfahren und die Vorrichtung abgetrennten Teilchen 115 das Sieb 121 nicht. Es wurde beobachtet, daß die Resistteilchen 115 auf der oberen Fläche des Siebes 121 bleiben, am Sieb 121 entlang nach unten fließen und schließlich in den Sammelbehälter 123 fallen, ohne das Sieb 121 zu verstopfen.

In Fig. 4 ist eine Vorrichtung mit einem drehbaren zylindrischen Sieb 421 dargestellt, das an der Achse 422 durch eine Aufhängevorrichtung 423 anstelle des Siebes 121 befestigt ist. Zur Entfernung der Resistteilchen von der Oberfläche des Siebes dient beispielsweise ein Schaber 402 oder eine ähnliche Einrichtung. Die Entschichtungslösung 113 fällt auf einen Sammelbehälter, hier als Küvette 431 ausgeführt, von dem sie dann wieder in den Entschichtungsprozeß zurückgeführt werden kann. Die Rückführung wird durch geeignete Einrichtungen, wie beispielsweise eine Pumpe, einen Siphon oder ähnliche Anordnungen, erreicht.

Nach dem Entfernen der Resistteilchen 115 von der Oberfläche des Siebes 421 und dem Auffangen in Sammelbehältern können sie in geeigneter Weise zur Entsorgung behandelt werden.

Das Sieb 121, 421 hat vorzugsweise Maschenöffnungen von etwa 100 µm Größe mit einer Maschendichte von etwa 67 Maschen/cm und einer Fadendicke von etwa 50 µm. Diese Konstruktion ermöglicht eine offene Fläche von etwa 45%. Ein geeignetes Sieb ist beispielsweise in Abhängigkeit von der Art des Resists, der Zusammensetzung, der Viskosität der Entschichtungsflüssigkeit und dem Temperaturbereich der die Resistteilchen enthaltenden Lösung zu wählen.

Unabhängig von der Art der Teilchenentfernung nach dem erfindungsgemäßen Verfahren befinden sich die Resistteilchen nur für kurze Zeit in Kontakt mit der Lösung. Die kurze Verweilzeit ermöglicht eine wiederholte Nutzung des Entschichtungsmittels, ohne daß es stark mit Resist belastet wird und ohne daß es seine Verwendbarkeit zum Entfernen des Resists von der Leiterplatte verliert. Die Abtrennung der Resistteilchen 115 von der Entschichtungslösung ist größer als 99,5%, d.h. Weniger als etwa 0,5% des Resists, der ursprünglich in der Lösung 111 enthalten war, paasiert das Sieb 121 mit der Entschichtungslösung 113 und verbleibt in der Lösung.

Das Verfahren ist vorzugsweise zum Entfernen von Resistteilchen aus Entschichtungslösungen für Leiterplatten geeignet, indem die mit Resist beladene Lösung zu der erfindungsgemäßen Vorrichtung befördert, dort vom Resist befreit und anschließend wieder in den Leiterplattenprozeß zurückgeführt wird. Das Verfahren zur Entfernung von Resistteilchen von der Leiterplatte mittels einer Entschichtungslösung in einer hierzu geeigneten Entschichtungsvorrichtung kann somit zusammen mit der erfindungsgemäßen Vorrichtung in einer kontinuierlichen Verfahrensweise angewendet werden.

Es ist jedoch auch denkbar, daß das Verfahren und die Vorrichtung auch zur Abtrennung von feinen quellbaren Polymer-Teilchen aus Dispersionen, die in anderen Herstellungs- oder Arbeitsverfahren anfallen, geeignet ist.

Bei einem ununterbrochenen Produktionsbetrieb mit drei Schichten kann die Leiterplatten-Entschichtung daher ohne zeitliche Unterbrechung betrieben werden, ohne daß die Anlage wegen einer Wartung der Vorrichtungen abgestellt oder die verbrauchte Entschichtungslösung ersetzt werden muß.

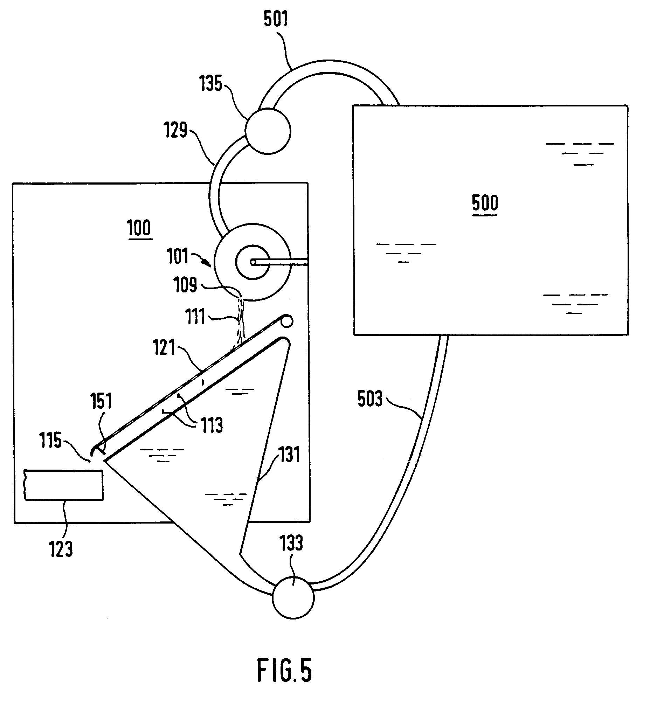

Die Vorrichtung kann in Verbindung mit einer Vorrichtung zum Herstellen von Leiterplatten und zum Entfernen von Resistteilchen verwendet werden. In Fig. 5 ist eine Vorrichtung, wie in Fig. 1 beschrieben, dargestellt, die mit der Leiterplattenentschichtungsvorrichtung 500 kombiniert ist. Derartige Vorrichtungen sind bekannt. Die Entschichtungslösung mit den darin dispergierten Resistteilchen wird durch eine geeignete Leitung 501 mittels einer Umwälzeinrichtung 135, beispielsweise einer Pumpe, zur Homogenisier- und Verteileinrichtung 101 zur Behandlung nach dem anhand der Fig. 1 geschilderten Verfahren befördert. Die filtrierte Lösung 113 wird auch hier von den Sammelbehältern 131 mittels Pumpen 133 und über weitere Leitungen 503 zur Vorrichtung 500 zur Entschichtungsvorrichtung zurückgeführt.

Anhand der nachfolgenden Beispiele wird die Erfindung erläutert:

### Vergleichsbeispiel:

Bei einem Entschichtungsprozeß wurde eine Hydrozyklonfiltrierung nach dem Stand der Technik eingesetzt, um Resistteilchen von der Entschichtungslösung abzutrennen. Nach einer Betriebszeit der Entschichtungsanlage von etwa 40 Stunden mit einer wäßrigen Lösung, enthaltend 15 Gew.-% einer Mischung aus 75 Gew.-% Triethanolamin und 25 Gew.-% NaOH, bei einer Temperatur von 50°C, kontinuierlicher Abtrennung der Resistteilchen von der Entschichtungslösung und Rückführung der Lösung zur Entschichtungsvorrichtung, war es notwendig, den Betrieb zu unterbrechen, um die benutzte Entschichtungslösung durch eine frische zu ersetzen, da deren Wirksamkeit für eine Entschichtung nicht mehr ausreichend war.

### Beispiel 1:

Eine Lösung von 15 Gew.-% Ethylendiamintetraessigsäure in einer alkalischen wäßrigen Lösung wurde als Entschichtungslösung hergestellt und bei einer Temperatur von 50°C verwendet. Nach dem Entfernen der Resistteilchen wurde die Lösung, die aus einer Flüssigkeit mit von einer Leiterplatte entfernten Resistteilchen bestand, in die erfindungsgemäße Homogenisier- und Verteileinrichtung befördert. Die Lösung wurde anschließend vom Außenrohr der Einrichtung durch einen Schlitz herabgeleitet, so daß sie auf das zur Abtrennung der Resistteilchen vorgesehene flache Sieb fiel. Die filtrierte Flüssigkeit wurde zur Entschichtungsvorrichtung zurückgeführt. Die Resistteilchen wurden verworfen. Nach einer Betriebszeit von 480 Stunden bei einer Temperatur von 50°C und kontinuierlicher Filtrierung und Rückführung der Lösung zur Entschichtungsanlage waren das Aussehen und die physikalischen Eigenschaften der Entschichtungslösung unverändert. Der Entschichtungsprozeß konnte problemlos weitergeführt werden.

### Beispiele 2 bis 10:

Die Verfahrensweise von Beispiel 1 wurde wiederholt, indem wäßrige Lösungen der in der nachfolgenden Tabelle angeführten Entschichtungsmittel verwendet wurden:

| Beispiel Nr. | Entschichtungsmittel | Lösung [Gew.-% in Wasser] | Betriebszeit [Stunden] |
|---|---|---|---|
| 2 | KOH/(HOCH₂CH₂)₃N | 5/10 | 400 |
| 3 | Cholin/(CH₃)₃N | 5/5 | 900 |
| 4 | (HOCH₂CH₂)NH₂ | 5 | 1200 |
| 5 | (HOCH₂CH₂)NH₂ | 40 | 800 |
| 6 | [(CH₃)₄N]⁺[OH]⁻ | 10 | 320 |
| 7 | (HOCH₂CH₂)₃N | 40 | 750 |
| 8 | EDTA | 35 | 700 |
| 9 | HO-C₂H₄-NH-C₂H₄-NH₂ | 35 | 1000 |
| 10 | (HOCH₂)₃N | 40 | 850 |

Die mit den Lösungen von jedem Beispiel erhaltenen Ergebnisse waren ausgezeichnet; das Entschichtungsmittel war sichtbar unverändert, die Entschichtung des Resists von den Leiterplatten konnte fortgesetzt werden, ohne eine Verringerung in der Wirkung festzustellen. Eine Unterbrechung des Versuches war lediglich zu Beginn eines neuen Tests notwendig.

Die Vorteile der Erfindung, die in einer praktisch vollständigen kontinuierlichen Abtrennung der Resistteilchen von der Entschichtungslösung ohne manuelle Wartung des Prozesses und der Vorrichtung auch bei längerer Prozeßdauer ohne Unterbrechung bestehen, ist damit demonstriert worden. Die einzigen Erfordernisse zur Aufrechterhaltung des Prozesses sind die periodische Beseitigung der Resistteilchen aus den Vorratsbehältern und ein gelegentlicher Stillstand des gesamten Systems zur Reinigung.

## Patentansprüche

1. Verfahren zum Entfernen von quellbaren Polymerteilchen aus einer flüssigen Dispersion, bestehend aus einer Lösung und darin enthaltenen, von der Lösung quellbaren Polymerteilchen, durch Filtration, gekennzeichnet durch die Verfahrensschritte:
- die Dispersion (111) wird durch gründliches Mischen homogenisiert,
- die Dispersion (111) wird zum Rückhalten der gequollenen Polymerteilchen (115) auf eine gegenüber der Vertikalen geneigte, als Trennmittel zur mechanischen Trennung der Polymerteilchen (115) von der Lösung (113) geeignete, flache Filterfläche (121) gleichmäßig aufgetragen,
- die von der Filterfläche (121) abrutschenden Polymerteilchen (115) und die nach Durchtritt durch die Filterfläche (121) erhaltene Lösung (113) werden unterhalb der Filterfläche wieder aufgefangen.

2. Verfahren zum Entfernen von quellbaren Polymerteilchen aus einer flüssigen Dispersion, bestehend aus einer Lösung und darin enthaltenen, von der Lösung quellbaren Polymerteilchen, durch Filtration, gekennzeichnet durch die Verfahrensschritte:
- die Dispersion (111) wird durch gründliches Mischen homogenisiert,
- die Dispersion (111) wird auf eine Mantelfläche eines drehbaren zylindrischen Siebes (421) von oben gleichmäßig aufgetragen, wobei die Polymerteilchen (115) durch eine geeignete Vorrichtung von der Sieboberfläche entfernt werden und die Lösung (113) nach Durchtritt durch die Mantelfläche wieder aufgefangen wird.

3. Verfahren nach Anspruch 1 oder 2, dadurch gekennzeichnet, daß die Dispersion (111) zum Homogenisieren durch eine Anordnung mehrerer koaxial ineinander angeordneter perforierter Rohre (103; 105) geleitet wird.

4. Verfahren nach einem der vorstehenden Ansprüche, dadurch gekennzeichnet, daß die Lösung zur weiteren Verwendung wieder aufgearbeitet und in einen Behandlungsbehälter (500) zurückgeführt wird.

5. Verfahren zum Entfernen von Resistschichten von Leiterplattenoberflächen mit den Verfahrensschritten
- In-Kontakt-Bringen der Leiterplattenoberflächen mit einer Lösung, enthaltend eine oder mehrere der Verbindungen a), b) und c):
a) Alkanolamine, insbesondere Methanolamin, Ethanolamin, Dimethanolamin, Diethanolamin, Trimethanolamin, Triethanolamin und HO-C₂H₄-NH-C₂H₄-NH₂ , Ethylendiamintetraessigsäure und deren Salze, Cholin und dessen Derivate
b) eine ionische Stickstoffverbindung mit der allgemeinen Formel
(N_{y} R' ''_{w})⁺(A)⁻
wobei R''' =substituierte oder unsubstituierte, lineare oder verzweigte Alkylgruppe mit 1 bis 10 Kohlenstoffatomen mit Substituenten, ausgewählt aus der Gruppe der Wasserstoff-, Halogen-, Sauerstoff-, Stickstoff- oder Schwefelatome enthaltenden funktionellen Gruppen,
A = ein anorganisches oder organisches Anion,
y gleich 1 und w gleich 4 ist, sowie
c) ein Alkali-oder Erdalkalimetallhydroxid,
wobei eine Resistteilchen (115) enthaltende Dispersion (111) gebildet wird,
- Abtrennen der Resistteilchen (115) aus der Dispersion (111) mit einem Verfahren nach einem der vorstehenden Ansprüche, wobei eine von Resistteilchen (115) im wesentlichen freie Lösung (113) gebildet wird,
- In-Kontakt-Bringen der Leiterplattenoberfläche mit der von Resistteilchen (115) im wesentlichen freien Lösung (113).

6. Verfahren nach Anspruch 5, dadurch gekennzeichnet, daß eine Kontaktzeit der Polymerteilchen (115) mit der Lösung (113) von etwa 20 Sekunden bis 5 Minuten eingestellt wird.

7. Vorrichtung zum Entfernen von quellbaren Polymerteilchen aus einer flüssigen Dispersion, bestehend aus einer Lösung und den darin enthaltenen, mit der Lösung quellbaren Polymerteilchen, umfassend:
- eine Trenneinrichtung (121) zur Abtrennung der Polymerteilchen (115), von der Lösung (113), wobei die Trenneinrichtung (121) eine zur Vertikalen geneigte und als Sieb ausgebildete Filterfläche zum Durchlaß der Lösung (113) und zum Abgleiten der Polymerteilchen (115) aufweist,
- Mittel (129;135;501) zum Zuführen der Dispersion (111) zu einer Homogenisier- und Verteileinrichtung (101),
- eine oberhalb der Trenneinrichtung angebrachte Homogenisier- und Verteileinrichtung (101) zum gründlichen Mischen der Dispersion (111) und Suspendieren der Polymerteilchen (115) sowie zum Aufbringen der Dispersion auf die Filterfläche, und
- je eine Auffangvorrichtung (123;131) für Polymerteilchen (115) und Lösung (113) unterhalb der Trenneinrichtung (121),
dadurch gekennzeichnet, daß
- die Homogenisier- und Verteileinrichtung (101) ein perforiertes Innenrohr (103) zur axialen Zufuhr der Dispersion und zum radialen Durchlaß zugeführter Dispersion (111) zu einem als Verteileinrichtung ausgebildeten und zum Innenrohr (103) koaxial angeordneten Außenrohr (105) aufweist, wobei das Außenrohr (105) einen sich im wesentlichen über die gesamte Länge des Rohres erstreckenden Schlitz (109) aufweist.

8. Vorrichtung zum Entfernen von quellbaren Polymerteilchen aus einer flüssigen Dispersion, bestehend aus einer Lösung und den darin enthaltenen, mit der Lösung quellbaren Polymerteilchen, umfassend:
- eine Trenneinrichtung (421),
- Mittel (129;135;501) zum Zuführen der Dispersion (111) zu einer Homogenisier- und Verteileinrichtung (101),
- eine Homogenisier- und Verteileinrichtung (101) zum gründlichen Mischen der Dispersion (111) und Suspendieren der Polymerteilchen (115), welche
- so angeordnet ist, daß die Dispersion (111) von der Homogenisier- und Verteileinrichtung (101) kommend von oben auf die Trenneinrichtung (421) auftragbar ist, und
- je eine Auffangvorrichtung (123;431) für Polymerteilchen (115) und Lösung (113) unterhalb der Trenneinrichtung (421),
dadurch gekennzeichnet, daß
- die Homogenisier- und Verteileinrichtung (101) ein perforiertes Innenrohr (103) zur axialen Zufuhr der Dispersion und zum radialen Durchlaß geführter Dispersion (111) zu einem als Verteileinrichtung ausgebildeten und zum Innenrohr (103) koaxial angeordneten Außenrohr (105) aufweist, wobei das Außenrohr (105) einen sich im wesentlichen über die gesamte Länge des Rohres erstreckenden Schlitz (109) aufweist, und
- wobei die Trenneinrichtung (421) eine Mantelfläche eines drehbaren, zylindrischen und parallel zum Schlitz (109) angeordneten Siebes ist und eine Vorrichtung (402) für das Abfördern der Polymerteilchen (115) von der Mantelfläche aufweist.

9. Vorrichtung nach einem der Ansprüche 7 und 8, dadurch gekennzeichnet, daß die Homogenisier- und Verteileinrichtung (101) aus zwei koaxial ineinander angeordneten Rohren (103;105) besteht, wobei das innere Rohr (103) mehrere Öffnungen (107) aufweist.

10. Vorrichtung nach einem der Ansprüche 7 bis 9, dadurch gekennzeichnet, daß die Position des Schlitzes (109) gegenüber der Position der Trenneinrichtung (121;421) einstellbar ist.

11. Vorrichtung nach einem der Ansprüche 7 bis 10, dadurch gekennzeichnet, daß der Schlitz (109) gegenüber der Vertikalen in einem Winkel von etwa 45 ° bis etwa 90 ° angeordnet ist.

12. Vorrichtung nach einem der Ansprüche 7, 9 bis 11, dadurch gekennzeichnet, daß das Sieb (121) flach ist, wobei die Siebebene in einem Winkel von etwa 35 ° bis etwa 85 ° gegen die Horizontale geneigt ist.

13. Vorrichtung nach einem der Ansprüche 7 bis 12, gekennzeichnet durch ein Sieb (121;421) mit Maschenöffnungen von etwa 60 µm bis etwa 250 µm Größe.

14. Vorrichtung nach einem der Ansprüche 7 bis 13, gekennzeichnet durch ein Sieb (121;421) mit Maschenöffnungen von etwa 75 µm bis etwa 120 µm Größe, mit einer Maschendichte von etwa 50 Maschen/cm bis etwa 85 Maschen/cm und einer Fadendicke von etwa 35 µm bis etwa 65 µm.

15. Verwendung einer Vorrichtung nach einem der Ansprüche 7 bis 14 zur Entfernung von Resistteilchen (115) aus einer zum Entschichten von Leiterplatten dienenden Lösung (113).

## Claims

1. Method of removing, by filtration, swellable polymer particles from a liquid dispersion, comprising a solution and polymer particles which are contained therein and are swellable by the solution, characterised by the method steps:
- the dispersion (111) is homogenised by thorough mixing,
- the dispersion (111) is uniformly applied to a flat filter face (121), which is inclined relative to the vertical and is suitable as the separating means for mechanically separating the polymer particles (115) from the solution (113), for retaining the swollen polymer particles (115), and
- the polymer particles (115), sliding down from the filter face (121), and the solution (113), which is obtained after passing through the filter face (121), are collected again beneath the filter face.

2. Method of removing, by filtration, swellable polymer particles from a liquid dispersion, comprising a solution and polymer particles which are contained therein and are swellable by the solution, characterised by the method steps:
- the dispersion (111) is homogenised by thorough mixing,
- the dispersion (111) is uniformly applied from above to a surface of a rotatable, cylindrical screen (421), the polymer particles (115) being removed from the screen surface by a suitable device, and the solution (113) being collected again by passing through the surface.

3. Method according to claim 1 or 2, characterised in that, for homogenising purposes, the dispersion (111) is conducted through an arrangement of a plurality of perforated tubes (103; 105), which are disposed coaxially one inside the other.

4. Method according to one of the preceding claims, characterised in that the solution is recovered again for further use and conducted back into a treatment container (500).

5. Method of removing resist layers from printed circuit board surfaces, having the method steps:
- bringing the printed circuit board surfaces in contact with a solution containing one or more of the compounds a), b) and c):
a) alkanol amines, more especially methanol amine, ethanol amine, dimethanol amine, diethanol amine, trimethanol amine, triethanol amine and HO-C₂H₄-NH-C₂H₄-NH₂, ethylene diamine tetraacetic acid and its salts, choline and its derivates,
b) an ionic nitrogen compound having the general formula
(N_{y} R'''_{w})⁺(A)⁻,
R''' being a substituted or unsubstituted, linear or branched alkyl group having 1 to 10 carbon atoms with functional groups containing substituents selected from the group of hydrogen, halogen, oxygen, nitrogen or sulphur
atoms,
A being an inorganic or organic anion,
y being equal to 1, and w being equal to 4, and
c) an alkali or alkaline earth metal hydroxide, a dispersion (111), containing resist particles (115), being formed,
- separating the resist particles (115) from the dispersion (111) using a method according to one of the preceding claims, a solution (113) being formed which is substantially free of resist particles (115), and
- bringing the printed circuit board surface in contact with the solution (113), which is substantially free of resist particles (115).

6. Method according to claim 5, characterised in that a contact time when the polymer particles (115) are in contact with the solution (113) of between roughly 20 seconds and 5 minutes is set.

7. Apparatus for removing swellable polymer particles from a liquid dispersion, comprising a solution and the polymer particles, which are contained therein and are swellable with the solution, including:
- a separating arrangement (121) for separating the polymer particles (115) from the solution (113), the separating arrangement (121) having a filter face, which is inclined relative to the vertical and is configured as a screen, for the solution (113) to pass therethrough and for the polymer particles (115) to slide away,
- means (129;135;501) for supplying the dispersion (111) to a homogenising and distributing arrangement (101),
- a homogenising and distributing arrangement (101), which is mounted above the separating arrangement, for the thorough mixing of the dispersion (111) and suspension of the polymer particles (115), as well as for applying the dispersion to the filter face, and
- a respective collecting device (123;131) for polymer particles (115) and solution (113) beneath the separating arrangement (121),
characterised in that
- the homogenising and distributing arrangement (101) includes a perforated internal tube (103) for axially supplying the dispersion and for the radial passage of supplied dispersion (111) to an external tube (105), which is configured as the distributing arrangement and is disposed coaxially relative to the internal tube (103), the external tube (105) having a slot (109), which extends substantially over the entire length of the tube.

8. Apparatus for removing swellable polymer particles from a liquid dispersion, comprising a solution and the polymer particles, which are contained therein and are swellable with the solution, including:
- a separating arrangement (421),
- means (129;135;501) for supplying the dispersion (111) to a homogenising and distributing arrangement (101),
- a homogenising and distributing arrangement (101) for the thorough mixing of the dispersion (111) and suspension of the polymer particles (115), which arrangement is so disposed that the dispersion (111), coming from the homogenising and distributing arrangement (101), can be applied to the separating arrangement (421) from above, and
- a respective collecting device (123;431) for polymer particles (115) and solution (113) beneath the separating arrangement (421),
characterised in that
- the homogenising and distributing arrangement (101) includes a perforated internal tube (103) for axially supplying the dispersion and for the radial passage of conducted dispersion (111) to an external tube (105), which is configured as the distributing arrangement and is disposed coaxially relative to the internal tube (103), the external tube (105) having a slot (109), which extends substantially ever the entire length of the tube, and
- the separating arrangement (421) being a surface of a rotatable, cylindrical screen, which is disposed parallel to the slot (109), and having a device (402) for conveying the polymer particles (115) away from the surface.

9. Apparatus according to one of claims 7 and 8, characterised in that the homogenising and distributing arrangement (101) comprises two tubes (103;105), which are disposed coaxially one inside the other, the internal tube (103) having a plurality of apertures (107).

10. Apparatus according to one of claims 7 to 9, characterised in that the position of the slot (109) is adjustable relative to the position of the separating arrangement (121;421).

11. Apparatus according to one of claims 7 to 10, characterised in that the slot (109) is disposed at an angle of between roughly 45° and roughly 90° relative to the vertical.

12. Apparatus according to one of claims 7, 9 to 11, characterised in that the screen (121) is flat, the screen plane being inclined at an angle of between roughly 35° and roughly 85° relative to the horizontal.

13. Apparatus according to one of claims 7 to 12, characterised by a screen (121;421) having mesh openings of a dimension of between roughly 60 µm and roughly 250 µm.

14. Apparatus according to one of claims 7 to 13, characterised by a screen (121;421) having mesh openings of a dimension of between roughly 75 µm and roughly 120 µm, a mesh density of between roughly 50 meshes/cm and roughly 85 meshes/cm and a filament thickness of between roughly 35 µm and roughly 65 µm.

15. Use of an apparatus according to one of claims 7 to 14 for the removal of resist particles (115) from a solution (113), which serves to remove layers from printed circuit boards.

## Revendications

1. Procédé d'élimination par filtration de particules de polymère susceptibles de gonfler à partir d'une dispersion liquide composée d'une solution et de particules de polymère contenues dans ladite solution et pouvant être gonflées par celle-ci, caractérisé par les étapes de procédé consistant à :
- homogénéiser la dispersion (111) en la mélangeant intimement,
- afin de retenir les particules de polymère (115) gonflées, déposer la dispersion (111) de manière uniforme sur une surface filtrante plane (121) inclinée par rapport à la verticale, appropriée pour servir de moyen de séparation permettant de séparer mécaniquement les particules de polymère (115) de la solution (113),
- récupérer les particules de polymère (115) qui tombent en glissant de la surface filtrante (121) et la solution (113) obtenue après avoir traversé la surface filtrante (121) en dessous de ladite surface filtrante.

2. Procédé d'élimination par filtration de particules de polymère susceptibles de gonfler à partir d'une dispersion liquide composée d'une solution et de particules de polymère contenues dans ladite solution et pouvant être gonflées par celle-ci, caractérisé par les étapes de procédé consistant à :
- homogénéiser la dispersion (111) en la mélangeant intimement,
- déposer la dispersion (111) de manière uniforme sur une surface d'enveloppe d'un tamis cylindrique rotatif (421) en partant du haut, les particules de polymère (115) étant évacuées de la surface du tamis au moyen d'un dispositif approprié et la solution (113) étant récupérée après avoir traversé la surface d'enveloppe.

3. Procédé selon la revendication 1 ou la revendication 2, caractérisé en ce que l'on fait passer la dispersion (111) dans un agencement de plusieurs tubes perforés (103, 105) disposés coaxialement à l'intérieur les uns des autres dans le but de l'homogénéiser.

4. Procédé selon l'une des revendications précédentes, caractérisé en ce que la solution est retraitée en vue de sa réutilisation et renvoyée dans une cuve de traitement (500).

5. Procédé d'élimination de couches de vernis épargne sur des surfaces de circuits imprimés, comprenant les étapes consistant à :
- mettre en contact les surfaces des circuits imprimés avec une solution contenant un ou plusieurs des composés a), b) et c) :
a) des alcanolamines, notamment la méthanolamine, l'éthanolamine, la diméthanolamine, la diéthanolamine, la triméthanolamine, la triéthanolamine et HO-C₂H₄-NH-C₂H₄-NH₂, l'acide éthylène diamine tétracétique et ses sels, la choline et ses dérivés ;
b) un composé azoté ionique de formule générale (N_{y}R'''_{w})⁺(A)⁻ dans laquelle :
R''' est un groupe alkyle linéaire ou ramifié, substitué ou non substitué, possédant de 1 à 10 atomes de carbone et des substituants choisis entre des groupes fonctionnels contenant des atomes d'hydrogène, halogène, oxygène, azote ou soufre,
A est un anion inorganique ou organique,
y est égal à 1 et w est égal à 4 ; et
c) un hydroxyde de métal alcalin ou de métal alcalino-terreux,
de manière à former une dispersion (111) contenant des particules de vernis épargne (115) ;
- séparer les particules de vernis épargne (115) de la dispersion (111) au moyen d'un procédé selon l'une des revendications précédentes, de manière à obtenir une solution (113) essentiellement exempte de particules de vernis épargne (115) ;
- mettre en contact la surface du circuit imprimé avec la solution (113) essentiellement exempte de particules de vernis épargne (115).

6. Procédé selon la revendication 5, caractérisé en ce que le temps de contact des particules de polymère (115) avec la solution (113) est réglé à une valeur comprise entre 20 secondes et 5 minutes environ.

7. Dispositif d'élimination de particules de polymère susceptibles de gonfler à partir d'une dispersion liquide composée d'une solution et de particules de polymère contenues dans ladite solution et pouvant être gonflées par celle-ci, comprenant :
- un dispositif de séparation (121) destiné à séparer les particules de polymère (115) de la solution (113), ledit dispositif de séparation (121) comportant une surface filtrante inclinée par rapport à la verticale et constituant un tamis qui laisse passer la solution (113) et fait glisser vers le bas les particules de polymère (115) ;
- des moyens (129, 135, 501) permettant d'amener la dispersion (111) à un dispositif d'homogénéisation et de distribution (101) ;
- un dispositif d'homogénéisation et de distribution (101) disposé au-dessus du dispositif de séparation et destiné à mélanger intimement la dispersion (111) et mettre en suspension les particules de polymère (115) ainsi qu'à déposer la dispersion sur la surface filtrante ; et
- un dispositif collecteur (123, 131) respectivement pour les particules de polymère (115) et pour la solution (113) en dessous du dispositif de séparation (121),
caractérisé en ce que :
- le dispositif d'homogénéisation et de distribution (101) comporte un tube perforé interne (103) servant à alimenter axialement la dispersion (111) et à laisser passer radialement la dispersion (111) alimentée vers un tube externe (105) conçu pour servir de dispositif de distribution et disposé coaxialement au tube interne (103), ledit tube externe (105) présentant une fente (109) qui s'étend essentiellement sur toute la longueur du tube.

8. Dispositif d'élimination de particules de polymère susceptibles de gonfler à partir d'une dispersion liquide composée d'une solution et de particules de polymère contenues dans ladite solution et pouvant être gonflées par celle-ci, comprenant :
- un dispositif de séparation (421) ;
- des moyens (129, 135, 501) permettant d'amener la dispersion (111) à un dispositif d'homogénéisation et de distribution (101) ;
- un dispositif d'homogénéisation et de distribution (101) destiné à mélanger intimement la dispersion (111) et mettre en suspension les particules de polymère (115), agencé de telle sorte que la dispersion (111) peut être déposée sur le dispositif de séparation (421) depuis le dispositif d'homogénéisation et de distribution (101) en partant du haut ; et
- un dispositif collecteur (123, 431) respectivement pour les particules de polymère (115) et pour la solution (113) en dessous du dispositif de séparation (421),
caractérisé en ce que :
- le dispositif d'homogénéisation et de distribution (101) comporte un tube perforé interne (103) servant à alimenter axialement la dispersion (111) et à laisser passer radialement la dispersion (111) alimentée vers un tube externe (105) conçu pour servir de dispositif de distribution et disposé coaxialement au tube interne (103), ledit tube externe (105) présentant une fente (109) qui s'étend essentiellement sur toute la longueur du tube ; et
- le dispositif de séparation (421) étant constitué par une surface d'enveloppe d'un tamis cylindrique rotatif disposé parallèlement à la fente (109) et comportant un dispositif (402) destiné à évacuer les particules de polymère (115) de ladite surface d'enveloppe.

9. Dispositif selon la revendication 7 ou la revendication 8, caractérisé en ce que le dispositif d'homogénéisation et de distribution (101) se compose de deux tubes (103, 105) disposés coaxialement l'un à l'intérieur de l'autre, le tube interne (103) comportant plusieurs ouvertures (107).

10. Dispositif selon l'une quelconque des revendications 7 à 9, caractérisé en ce que la position de la fente (109) est réglable par rapport à la position du dispositif de séparation (121, 421).

11. Dispositif selon l'une quelconque des revendications 7 à 10, caractérisé en ce que la fente (109) est disposée selon un angle allant de 45° environ à 90° environ par rapport à la verticale.

12. Dispositif selon l'une quelconque des revendications 7 et 9 à 11, caractérisé en ce que le tamis (121) est plat, le plan du tamis étant incliné selon un angle de 35° environ à 85° environ par rapport à l'horizontale.

13. Dispositif selon l'une quelconque des revendications 7 à 12, caractérisé en ce que le tamis (121, 421) a une ouverture de maille de taille comprise entre 60 µm environ et 250 µm environ.

14. Dispositif selon l'une quelconque des revendications 7 à 13, caractérisé en ce qu'il comporte un tamis (121, 421) avec des ouvertures de mailles d'une taille comprise entre 75 µm environ et 120 µm environ, une densité de maille de 50 mailles par cm environ à 85 mailles par cm environ, et une épaisseur de fil comprise entre 35 µm environ et 65 µm environ.

15. Utilisation d'un dispositif selon l'une quelconque des revendications 7 à 14 pour éliminer des particules de vernis épargne (115) d'une solution (113) servant à enlever des couches de circuits imprimés.
